# EUROPÄISCHE PATENTSCHRIFT

(11) **EP 3 867 651 B1**
(45) Veröffentlichungstag und Bekanntmachung des Hinweises auf die Patenterteilung: **21.02.2024**
(21) Anmeldenummer: 18829214.8
(22) Anmeldetag: 05.12.2018
(51) Int. Cl.: G01R 31/12, G01R 19/165, G01R 31/14, G01R 31/52, G01R 19/18, G01R 27/02, G01R 15/16, H01C 7/12

(54) **MESSVORRICHTUNG, ELEKTRISCHE ANLAGE MIT MESSVORRICHTUNG UND VERFAHREN ZUM MESSEN EINES LECKSTROMES**
MEASURING DEVICE, ELECTRICAL SYSTEM HAVING A MEASURING DEVICE AND METHOD FOR MEASURING A LEAKAGE CURRENT
DISPOSITIF DE MESURE, INSTALLATION ÉLECTRIQUE COMPRENANT UN DISPOSITIF DE MESURE ET PROCÉDÉ DE MESURE D'UN COURANT DE FUITE

(43) Veröffentlichungstag der Anmeldung: 25.08.2021
(73) Patentinhaber: Siemens Energy Global GmbH & Co. KG, 81739 München (DE)
(72) Erfinder: ARMSCHAT, Christoph, 91058 Erlangen (DE); AUGSBURGER, Friedemann, 90518 Altdorf (DE)
(86) Internationale Anmeldenummer: PCT/EP2018/083667
(87) Internationale Veröffentlichungsnummer: WO 2020/114593

(56) Entgegenhaltungen:
- EP-A1- 2 884 292
- WO-A2-02/101901
- CN-B- 105 510 778
- RU-C1- 2 620 021
- US-A1- 2012 206 153
- US-A1- 2018 108 461

## Beschreibung

Die Erfindung betrifft eine Vorrichtung zum Messen eines Leckstromes.

Ein Leckstrom ist ein Strom, der außerhalb der für einen Betrieb einer elektrischen Anlage vorgesehenen Leiterbahnen fließt. Als Leckströme können auch Ströme verstanden werden, die im Aktivteil von Ableitern durch MOX Scheiben fließen, wenn der Ableiter nicht "anspricht", also temperaturabhängig auch im Normalbetrieb. Ein Leckstrom, der über Oberflächen von Isolatoren fließt, wird auch als Kriechstrom bezeichnet. Insbesondere in Hoch- und Mittelspannungsanlagen fließen über dort eingesetzte Isolatoren oft Leck- bzw. Kriechströme aufgrund der dort auftretenden Spannungsunterschiede von mehreren Kilovolt. Diese Oberflächen-Leckströme bzw. Kriechströme entstehen insbesondere durch Feuchtigkeit und Verschmutzung der meist im Freien aufgestellten Komponenten der Anlage und sind im Allgemeinen unerwünscht. Solche Leckströme liegen üblicherweise im Bereich von einigen 10 Mikro-Ampere bis zu wenigen Milliampere.

Bekannte Strommessvorrichtungen sind oft zum Messen von Leckströmen ungeeignet, weil sie zu groß sind und ihre Installation kostenintensiv ist. Platzierung von konventioneller Mess- und Funktechnik ist darüber hinaus wegen des Energiebedarfs langfristig meist nur auf Erdpotential möglich.

Eine Vorrichtung zum Messen eines Leckstromes ist aus der CN 105 510 778 B bekannt.

Die WO 02/101901 A2 offenbart eine Parallelschaltung eines Kondensators und eines Widerstandes, um eine vorbestimmte Stromstärke zum Auslösen einer Schwellwertschaltung zu benutzen.

In der US 2018/108461 A1 ist eine Vorrichtung zum Überwachen einer Temperatur eines Überspannungsableiters beschrieben.

Die EP 2 884 292 A1 offenbart ein Verfahren zum Messen eines Leckstromes auf Oberflächen von Isolatoren.

Aus der US 2012/206153 A1 ist ein weiteres Verfahren zum Messen eines Leckstromes bekannt.

Die RU 2 620 021 C1 beschreibt ein Verfahren zum Überwachen elektrischer Freileitungen auf Isolationsfehler.

Die Aufgabe der Erfindung ist es, eine artgemäße Vorrichtung vorzuschlagen, die möglichst kostengünstig und zuverlässig ist.

Die Aufgabe wird durch eine Vorrichtung zum Messen eines Leckstromes gelöst, mit einer ersten und einer zweiten Elektrode zum Platzieren bzw. Anordnen in einem Leckstrompfad, mit einem Energiespeicher, der derart mit den Elektroden verschaltet ist, dass er mittels des Leckstromes aufladbar ist, sowie mit einem Funkmodul, der mit dem Energiespeicher verbunden und dazu eingerichtet ist, ein Funksignal zu senden, wenn eine Energiespeicherspannung am Energiespeicher einen vorbestimmten Spannungsschwellwert der einem Energieinhalt entspricht erreicht oder überschreitet. Erfindungsgemäß ist ein kompakter und kostengünstiger Stromsensor zum Messen von Leckströmen bereitgestellt. Die Elektroden können in einer einfachen Ausführung jeweils aus einem sich über eine vorbestimmte Länge erstreckenden Leiterstück hergestellt sein. Zweckmäßigerweise wird über die metallische Elektrode der gesamte Leckstrom der Komponente aufgenommen, durch die Messeinrichtung geführt und danach wieder auf die Oberfläche des Prüflings verteilt oder alternativ dem Erdpfad zugeführt.

Der Energiespeicher und das Funkmodul können in einem etwa erbsengroßen Sensorknoten zusammengefasst sein. Eine mögliche rundliche Bauform kann als vorteilhaft für die elektrische Feldsteuerung angesehen werden, da somit Teilentladungen im elektrischen Feld weitgehend vermieden werden (keine Spitzen- bzw. Kantenwirkung). Mit der einfachen und kompakten Bauweise kann die erfindungsgemäße Vorrichtung vorteilhaft einfach auf Isolatoren und anderen Bauteilen elektrischer Anlagen auf Erdpotential oder auch auf (Hochspannungs-) Potential angebracht werden.

Des Weiteren benötigt die erfindungsgemäße Vorrichtung keine zusätzliche Energieversorgung, da sich der Energiespeicher und das Funkmodul aus dem zu messenden Leckstrom selbst speisen. Das Funkmodul kann beispielsweise angelehnt an die bekannte RFID-Technologie ausgebildet sein, so dass es lediglich eine kleine Energiemenge zum Senden der Funksignale benötigt. Die Funksignale können aus einzelnen Pulsen oder aber auch aus Funksprüchen bestehen, die Zusatzinformationen (z.B. eine ID Identifikationsnummer der Vorrichtung) enthalten können. Gemäß einem Beispiel kann das Funksignal aus einem modulierten Trägersignal bestehen. Die Trägerfrequenz des Trägersignals kann dabei zwischen 100 MHz und 5000 MHz liegen.

Das Funktionsprinzip der erfindungsgemäßen Vorrichtung sieht vor, dass der zwischen den Elektroden fließende Leckstrom den entladenen Energiespeicher auflädt, der im Allgemeinen beispielsweise ein Kondensator sein kann. Sobald der Energiespeicher bis zu einer vorbestimmten Spannungshöhe geladen ist, die durch den Spannungsschwellwert gegeben ist, wird die im Energiespeicher gespeicherte Energie dazu genutzt, das Funkmodul zu aktivieren, so dass dieses ein Funksignal sendet. Der auf diese Weise entladene Kondensator kann wieder durch den Leckstrom aufgeladen werden. Je höher der Leckstrom ist, desto kürzer ist die Aufladezeit des Energiespeichers. Mit dem hier beschriebenen Aufbau steigt demnach die Häufigkeit der gesendeten Funksignale mit einem steigenden Leckstrom. Auf diese Weise kann aus der Information über die Häufigkeit der Funksignale eine Information über den Leckstrom bzw. dessen Stromstärke gewonnen werden. Gleiche Information ist auch beispielsweise in den Zeitabständen zwischen den gesendeten Funksignalen enthalten. Diese kann dann von einer geeigneten Empfangsvorrichtung zum Empfangen der Funksignale des Funkmoduls ausgewertet werden. Die Vorrichtung kann zudem eine Logik-Einheit umfassen, die auch in das Funkmodul integriert sein kann. Mittels der Logik-Einheit kann die Aktivierung des Funkmoduls gesteuert werden. Die beiden Elektroden sind geeigneterweise voneinander beabstandet in dem Leckstrompfad, also dem Strompfad des Leckstromes, anzuordnen. Insbesondere bei einem Einsatz in Hoch- oder Mittelspannungsanlagen, wo die Spannungsunterschiede sehr hoch sind, ist es ausrechend, dass der Abstand zwischen den Elektroden wenige Millimeter beträgt, beispielsweise zwischen 2 mm und 5 mm. (Daumenregel: 250V pro 10mm Kriechweg) Zweckmäßigerweise ist das Funkmodul zu einer Kommunikation in nur einer Richtung eingerichtet bzw. ausgebildet. Das heißt, dass das Funkmodul lediglich Daten senden, nicht jedoch empfangen kann. Auf diese Weise ist die Vorrichtung vorteilhaft sicher gegen Eingriffe oder Manipulation von außen.

Gemäß einer Ausführungsform der Erfindung sind die erste Elektrode mit einem ersten Pol des Energiespeichers und die zweite Elektrode mit einem zweiten Pol des Energiespeichers verbunden. Es kann vorteilhaft sein, wenn der Energiespeicher hinter einen Gleichrichter geschaltet ist, dessen AC - Eingänge an die Elektroden und der DC Ausgang an den Energiespeicher angeschlossen ist. Somit ist der BSSN in einer einheitlichen Ausführung für AC Spannung und DC Spannung beider Polaritäten (verpolungssicher) verwendbar.

Das Funkmodul ist elektrisch parallel zum Energiespeicher angeordnet. Hierbei kann der Leckstrom direkt in den Energiespeicher fließen. Das Funkmodul wird geeigneterweise über eine Schwellwertschaltung nur sehr kurz an den Energiespeicher geschaltet. Nach Absetzen eines Funkspruchs ist der Energiespeicher durch die Energieentnahme zum Beispiel soweit entladen, dass das Funkmodul durch die Schwellwertschaltung vom Energiespeicher getrennt wird. Optional kann parallel zum Funkmodul kurzzeitig ein zweiter Energie-Verbraucher (Shunt widerstand) zugeschaltet sein, so dass der Energiespeicher mit jedem Sendevorgang um einen sinnvollen Betrag (z.B. 40%) entladen wird.

Vorzugsweise umfasst die Vorrichtung einen Entladewiderstand, der derart mit dem Energiespeicher verbunden ist, dass die Energiespeicherspannung erst dann den Spannungsschwellwert erreichen kann, wenn der Leckstrom einen vorbestimmten Stromschwellwert erreicht oder überschreitet. Mittels des Entladewiderstandes kann die Empfindlichkeit der Vorrichtung eingestellt bzw. festgelegt werden. Je höher der Widerstandswert des Entladewiderstandes, desto höherer Leckstrom ist nötig, um das Funkmodul zu aktivieren, bzw. den Energiespeicher bis zum Spannungsschwellenwert aufzuladen. Durch die Bereitstellung des Entladewiderstandes kann vorteilhaft vermieden werden, dass selbst bei minimalen Leckströmen oder Fehlauslösungen die Vorrichtung bereits anspricht. Bevorzugt ist der Entladewiderstand elektrisch parallel zum Energiespeicher angeordnet. Durch die integrierende Wirkung des Energiespeichers für Leckströme ist es möglich, dass auch die kurzeitig sehr hohen Streamer (Teilüberschläge über kurze Isolatorteilstücke) mit erfasst werden. Solche Streamer können den Energiespeicher schlagartig aufladen. Gegen Überladung ist der parallel geschaltete Ableiter installiert.

Es wird als vorteilhaft angesehen, wenn der Widerstandswert des Entladewiderstandes gezielt veränderbar ist. Dies kann beispielsweise dadurch erreicht werden, dass der Entladewiderstand mehrere zum Beispiel in Reihe geschaltete Teilwiderstände umfasst, wovon wenigstens einer, beispielsweise mittels nach außen geführter Anschlusspunkte von außen, überbrückbar ist. Es ist ebenfalls denkbar, dass zum Beispiel bei parallel geschalteten Teilwiderständen jeweils in Reihe zu jedem Widerstand eine Sicherung geschaltet ist, die mittels von außen zugeführter Überspannung geöffnet (zerstört) werden kann. Der parallele Pfad ist dann geöffnet und der parallele Widerstand ist für die Gesamtschaltung "herausgetrennt" und unwirksam. Somit kann wenigstens eines der Teilwiderstände durch eine gezielte Überspannung zerstört werden. Die Überspannung kann zum Beispiel durch Anlegen einer zusätzlichen Spannung an Anschlüssen erreicht werden, die aus einem Gehäuse der Vorrichtung herausgeführt und von außen zugänglich sind. Auf diese Weise kann die Empfindlichkeit der Vorrichtung selbst noch nach deren Inbetriebnahme eingestellt werden.

Zweckmäßigerweise ist ein Ableiter in Parallelschaltung zum Energiespeicher vorgesehen. Mittels des Ableiters kann vorteilhaft verhindert werden, dass der Energiespeicher oder andere Komponenten der Vorrichtung bei Überspannungen aufgrund von Teilüberschlägen (Streamer) auf der Isolatoroberfläche und den daraus resultierenden Stromstößen beschädigt oder zerstört werden. Der Ableiter kann beispielsweise ein Varistor oder auch ein geeigneter Überspannungsbegrenzer sein.

Gemäß der Erfindung umfasst die Vorrichtung eine Antenne, mittels der das Funksignal gesendet wird, wobei eine der Elektroden wenigstens einen Teil der Antenne ausbildet. Hierbei wird zumindest eine der Elektroden als zumindest ein Teil einer Antenne, insbesondere einer Dipolantenne, verwendet. Auf diese Weise kann vorteilhaft auf eine separate Antenne verzichtet werden.

Vorzugsweise umfasst die Vorrichtung Reflektordrosseln, die in die eine der Elektroden zur Festlegung einer Trägerfrequenz des Funksignals eingefügt sind. Mittels der voneinander beabstandet angeordneter Reflektordrosseln können die Reflexionspunkte der Dipolantenne definiert werden. Die Entfernung der Reflektordrosseln entlang der Elektrode, in die diese eingefügt sind, entspricht einem Vielfachen der halben Wellenlänge der Übertragungsfrequenz bzw. Trägerfrequenz des Funksignals.

Gemäß einer weiteren Ausführungsform der Erfindung umfasst die Vorrichtung ferner eine dritte Elektrode, die mit dem Funkmodul verbunden ist, so dass eine Spannung zwischen der dritten Elektrode und dem Funkmodul messbar ist. Die dritte Elektrode dient zur Spannungsmessung der Spannung auf der Isolatoroberfläche. Die gemessene Spannung kann als eine zusätzliche Information zur Längs-Spannungsverteilung über dem Isolator fungieren, die mittels des Funksignals übermittelt werden kann.

Vorzugsweise ist die dritte Elektrode mittels eines isolierten Widerstandsbandes mit dem Funkmodul und/oder mit dem Energiespeicher verbunden. Das Widerstandsband benötigt hierbei geeigneterweise mindestens eine Länge, die dem Abstand der Elektroden entspricht. Widerstandswert z.B. im Megaohm Bereich (=Größenordnung des Oberflächen - Isolationswidertandes des Isolators)

Zweckmäßigerweise sind die Elektroden über eine Gleichrichterbrücke mit dem Energiespeicher verbunden. Auf diese Weise kann eine unipolare Aufladung des Energiespeichers gewährleistet werden.

Im Hinblick auf die Bauweise der Elektroden wird es als vorteilhaft angesehen, wenn die erste und die zweite Elektrode jeweils ringförmig und konzentrisch zueinander angeordnet sind. Dies erlaubt einen besonders kompakten Aufbau der Vorrichtung.

Die beiden Elektroden können ferner auf einem gemeinsamen Trägerelement angeordnet und mit diesem verbunden sein. Die Befestigung der Elektroden kann beispielsweise mittels Klebung bei zum Beispiel zwei nach oben freiligenden metallischen Elektroden auf einem Trägerband vorliegen. Auf diese Weise ist die Anordnung der Elektroden im Leckstrompfad, zum Beispiel an einer Isolatoroberfläche, vorteilhaft erleichtert. Durch lückenlose Verklebung des Trägerbands mit der Isolatoroberfläche wird bevorzugt sichergestellt, dass sich für den Kriechstrom kein Nebenweg unter dem aufgeklebten Trägerband Band aufbauen kann: der komplette Kriechstrom wird von der Elektrode aufgenommen und in die Elektronik geleitet.

Die Erfindung betrifft ferner eine Elektrische Anlage mit einem Leiter, der von einem Isolator umgeben ist. Solche elektrischen Anlagen sind aus dem Stand der Technik bekannt. Insbesondere Hochspannungsanlagen umfassen beispielsweise Schaltanlagen, Überspannungsableiter, Erdungsleitungen und dergleichen. Insbesondere sind Leiter, die sich zwischen einem Hochspannungspotenzialpunkt und dem Erdpotenzial erstrecken, mit einem umgebenden Isolator versehen. Aufgrund der Spannungsunterschiede fließen über den Isolator, also entlang dessen Außenoberfläche, Leckströme in Form von Kriechströmen. Die Isolatoren sind meist im Freien aufgestellt, so dass Verschmutzung und Feuchtigkeit an deren Außenoberflächen meist unvermeidbar sind, die unter elektrischer Spannung zum Entstehen der Kriechströme führen.

Die Aufgabe der Erfindung ist es, eine artgemäße Anlage vorzuschlagen, die möglichst kostengünstig und zuverlässig ist.

Die Aufgabe wird bei einer erfindungsgemäßen elektrischen Anlage durch eine erfindungsgemäße Vorrichtung zum Messen eines über den Isolator fließenden Leckstromes gelöst.

Ein wichtiger Vorteil der erfindungsgemäßen Anlage ist die Möglichkeit der Messung des Leckstromes über dem Isolator. Auf diese Weise kann eine Beanspruchung der Anlage, insbesondere des Isolators, durch den Leckstrom überwacht werden. Somit kann die Zuverlässigkeit der gesamten Anlage erhöht werden.

Ist die elektrische Anlage eine Hoch- oder Mittelspannungsanlage, so ist die Verwendung der erfindungsgemäßen Vorrichtung besonders vorteilhaft, weil für diese keine aufwendige separate Energieversorgung bereitgestellt werden muss und die Signalübertragung keine zusätzliche Potenzialtrennung bzw. Isolierung erfordert.

Ein weiterer Vorteil der erfindungsgemäßen Anlage ergibt sich, wenn eine zusätzliche Spannungsmessung mittels der Vorrichtung bereitgestellt wird. Denn mittels der Vorrichtung kann in diesem Fall eine Isolatorabschnittsspannung gemessen werden. Isolatoren weisen häufig eine Spannungsfehlverteilung in deren Längsrichtung auf, die oft nur in Form von "dry-band arcing" (Teilentladungen) sichtbar wird. Kann mittels der erfindungsgemäßen Vorrichtung die Isolatorabschnittsspannung ermittelt werden, so kann eine Information über Spannungsbelastungen auf der Isolatoroberfläche gewonnen werden. Auf diese Weise kann u.a. eine Detektion von radialen Durchschlägen der entsprechenden Anlagekomponente vorteilhaft ermöglicht werden.

Die Erfindung betrifft des Weiteren ein Verfahren zum Messen eines Leckstromes.

Die Aufgabe der Erfindung ist es, ein solches Verfahren anzugeben, das möglichst kostengünstige und zuverlässige Messung erlaubt.

Die Aufgabe wird erfindungsgemäß durch ein zuvor genanntes Verfahren mit den folgenden Verfahrensschritten gelöst:
- Aufladen eines Energiespeichers, der mit einer ersten und einer zweiten Elektrode verbunden ist, die in einem Leckstrompfad des zu messenden Leckstromes angeordnet sind,
- Aussenden eines Funksignals, wobei das Funksignal mittels eines mit dem Energiespeicher verbundenen Funkmoduls gesendet wird, sobald eine Energiespeicherspannung am Energiespeicher einen vorbestimmten Spannungsschwellwert erreicht oder überschreitet.

Die Vorteile des erfindungsgemäßen Verfahrens ergeben sich insbesondere aus den Vorteilen, die bereits zuvor im Zusammenhang mit der dazu verwendeten erfindungsgemäßen Vorrichtung beschrieben wurden.

Die Erfindung wird im Folgenden anhand der Figuren 1 bis 5 weiter erläutert werden.
Figur 1 zeigt ein Beispiel für eine erfindungsgemäße elektrische Anlage in einer schematischen Darstellung;
Figur 2 zeigt eine Teilansicht (Isolatorschirm, Schnittdarstellung) der elektrischen Anlage der Figur 1 in einer schematischen Darstellung;
Figur 3 zeigt eine weitere Teilansicht (Isolatorschirm, Draufsicht) der elektrischen Anlage der Figur 1 in einer schematischen Darstellung;
Figur 4 zeigt eine Teilansicht eines Ausführungsbeispiels einer erfindungsgemäßen Vorrichtung in einer schematischen Darstellung;
Figur 5 zeigt ein weiteres Ausführungsbeispiel einer erfindungsgemäßen Vorrichtung in einer schematischen Darstellung.

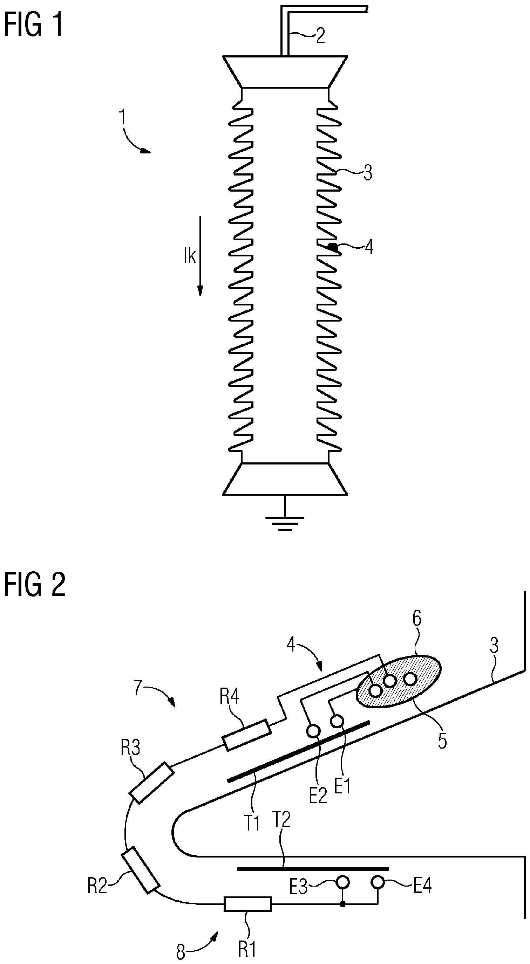

In Figur 1 ist eine elektrische Anlage gezeigt, die ein Überspannungsableiter 1 einer Hochspannungsanlage ist. Der Überspannungsableiter 1 ist zwischen einer Hochspannungsleitung 2 und der Erde angeordnet. Im Inneren des Überspannungsableiters 1 ist ein Leiter angeordnet (nicht sichtbar). Außen ist der Leiter von einem eine Vielzahl von Silikonschirmen umfassenden Isolator 3 umgeben. Der Überspannungsableiter 1 ist im Freien aufgestellt, so dass abhängig von Witterungsbedingungen die Außenoberfläche des Überspannungsableiters 1 verschmutzt oder feucht wird. Aufgrund des Potenzialunterschieds zwischen der Hochspannungsleitung 2 und Erde fließt bei verschmutztem und/oder feuchtem Isolator über dessen Außenoberfläche ein Kriechstrom, was in Figur 1 mit einem Pfeil Ik angedeutet ist. Am Isolator 3 bzw. an einem der Silikonschirme ist eine Vorrichtung 4 zum Messen des Kriechstromes angeordnet. Auf den Aufbau der Vorrichtung 4 wird anhand von Ausführungsbeispielen in den nachfolgenden Figuren näher eingegangen.

In Figur 2 ist ein vergrößerter Ausschnitt des Isolators 3 der Figur 1 dargestellt, an dem die Vorrichtung 4 angeordnet ist. Die Vorrichtung 4 umfasst eine erste Elektrode E1 und eine zweite Elektrode E2, die beide auf einem gemeinsamen Trägerelement T1 in Form eines Trägerbandes angeordnet und mit ihm mittels Klebung befestigt sind. Das Trägerelement T1 haftet wiederum auf der Außenoberfläche des Isolators 3 Die beiden Elektroden E1, E2 sind über Leiterstücke mit einem Sensorknoten 5 verbunden. Der Sensorknoten 5 umfasst ein Gehäuse 6 sowie einen darin angeordneten Energiespeicher und ein Funkmodul (in Figur 2 grafisch nicht dargestellt). Auf den Aufbau des Sensorknotens wird in den nachfolgenden Figuren näher eingegangen. Die beiden Elektroden E1 und E2 sowie der Sensorknoten 5 sind an einer Oberseite 7 des Silikonschirmes angeordnet.

An einer Unterseite 8 desselben Silikonschirmes sind eine dritte Elektrode E3 und eine vierte Elektrode E4 angeordnet, die auf einem gemeinsamen zweiten Trägerelement T2 befestigt sind. Die beiden Elektroden E3, E4 sind im dargestellten Beispiel miteinander elektrisch direkt und über eine Reihenschaltung von Widerständen R1-R4 mit dem Sensorknoten 5 verbunden.

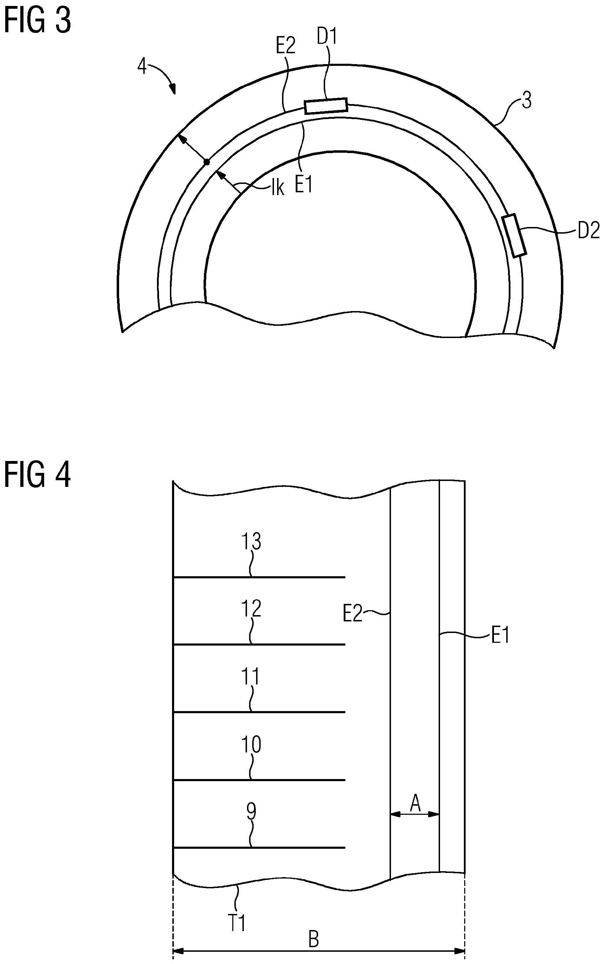

Figur 3 zeigt eine Draufsicht von oben auf eine Teilansicht des Silikonschirmes, auf dem die Vorrichtung 4 befestigt ist. Es ist erkennbar, dass die erste Elektrode E1 und die zweite Elektrode E2 jeweils ringfömig bzw. ellipsenförmig umlaufend auf der Isolatoraußenoberfläche des Isolators 3 angeordnet sind. Zudem sind die beiden Elektroden E1, E2 konzentrisch zueinander. Die Stromrichtung des Kriechstromes ist in Figur 2 mit einem Pfeil Ik angedeutet. Insbesondere ist erkennbar, dass auf der in Figur 3 dargestellten oberen Fläche des Silikonschirmes die Stromrichtung des Kriechstromes radial nach außen verläuft. Damit ist erkennbar, dass die beiden Elektroden im Kriechstrompfad angeordnet sind.

Die zweite Elektrode E2 hat (optional) die zusätzliche Funktion einer Antenne. Zur Festlegung der Antennenlänge und damit der Trägerfrequenz des Funksignals sind in die zweite Elektrode E2 eine erste und eine zweite Reflektordrossel D1 bzw. D2 eingefügt.

Figur 4 zeigt einen Teilausschnitt des Trägerelementes T1 mit den aufgebrachten Elektroden E1 und E2. Das Trägerelement T1 besteht im Wesentlichen aus einem auf der Oberseite und auf der Unterseite mit Kleber beschichteten, elastischen Trägermaterial und bildet entsprechend ein Trägerband. Das Trägerelement T1 weist größere Kantenlänge oder seitliche Einschnitte 9-13 auf, die ein Aufbringen auf einem runden Silikonschirm erleichtern, da das Band nach Aufbringen auf der einen Seite eine größere Kantenlänge als auf der anderen Seite aufweisen kann. Die zweite Elektrode E2 kann leicht gewellt sein, so dass sie, wenn aufgeklebt, eine größere Bogenlänge erlaubt.

Das Trägerelement T1 kann beispielsweise zur Installation auf dem Isolator 3 als Endlosband von einer Endlosrolle abgewickelt und direkt auf den Isolator aufgebracht (ggf. nach dessen vorheriger Reinigung) werden. Die Aufbringung muss frei von Luftspalten sein, damit kein Leckstrom unter dem Band in einem Parallelpfad fließen kann. Das zweite Trägerelement T2 der Figur 2 kann zum ersten Trägerelement T1 gleichartig aufgebaut und entsprechend mit gleicher Vorgehensweise auf der Unterseite des Silikonschirmes installiert werden.

Der Abstand A der beiden Elektroden E1, E2 beträgt im dargestellten Beispiel 3 mm. Die Breite B des Trägerelements T1 liegt bevorzugt zwischen 5 mm und 10 mm.

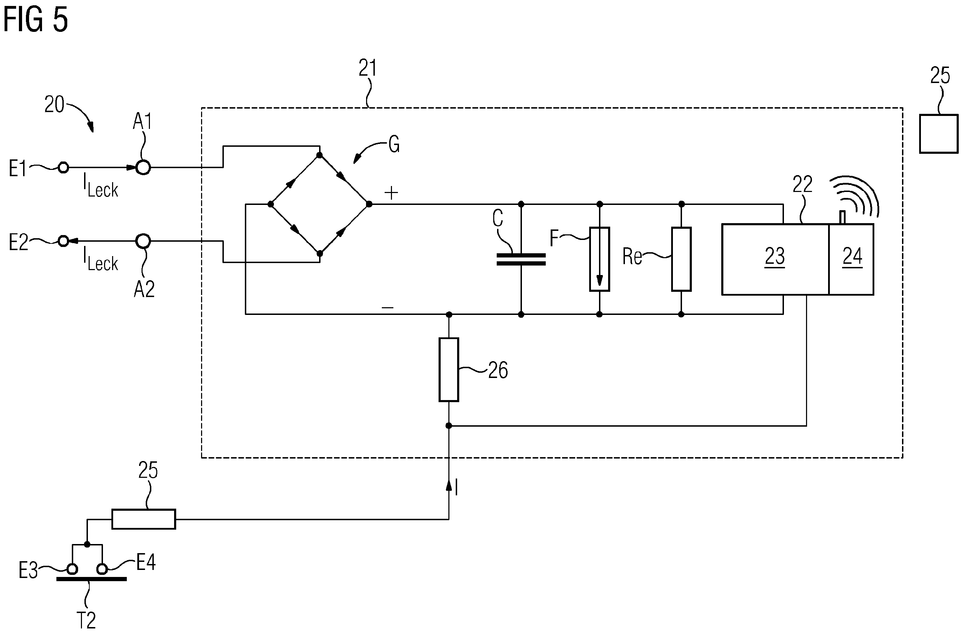

Figur 5 zeigt eine Vorrichtung 20 zum Messen eines Leckstromes (bzw. des Kriechstromes als Spezialfall des Leckstromes). Die Vorrichtung 20 ist hierbei beispielsweise für die Anordnung der Figuren 1 bis 4 als Vorrichtung 4 geeignet. Aus Gründen der Übersichtlichkeit sind daher gleiche und gleichartige Elemente der Figuren 1 bis 5 bzw. der Vorrichtung 4 der Figuren 1 bis 4 und der Vorrichtung 20 mit gleichen Bezugszeichen versehen.

Die Vorrichtung 20 umfasst eine erste Elektrode E1 und eine zweite Elektrode E2, die in den Leckstrompfad zu platzieren sind (beispielsweise in der in den Figuren 1 bis 4 dargestellten Weise). Die Elektroden E1, E2 sind jeweils mit einem Anschluss A1 bzw. A2 eines Sensorknotens 21 elektrisch verbunden, der über ein eigenes Gehäuse verfügt, aus dem die Anschlüsse A1, A2 herausgeführt sind.

Der Sensorknoten 21 umfasst einen Energiespeicher in Form eines Kondensators C. In einer Parallelschaltung zum Kondensator C ist ferner ein Überspannungsbegrenzer in Form eines Varistors F angeordnet, der die Spannung über dem Kondensator auf vorzugsweise 5 V bis 50 V, besonders bevorzugt auf weniger als 15 V, begrenzt. Parallel zum Kondensator C ist ferner ein Entladewiderstand Re vorgesehen, dessen Widerstandswert bevorzugt zwischen 10 kOhm und 50 kOhm liegt. Die Elektroden E1, E2 sind über eine Gleichrichterbrücke G mit dem Kondensator C verbunden.

Der Sensorknoten 21 umfasst ferner ein Funkmodul 22, das eine Logik-Einheit 23 und einen Radio-Transmitter 24 aufweist.

Die Vorrichtung 20 umfasst ferner eine dritte und eine vierte Elektrode E3, E4, die auf einem gemeinsamen Trägerelement T2 angeordnet sind. Aus der Darstellung der Figur 5 wird es deutlich, dass entsprechend den Ausführungen zur Figur 4 die Elektroden E1, E2 mit ihrem zugeordneten Trägerelement gleichem Endlosband entnommen werden können, wie die Elektroden E3 und E4 mit ihrem Trägerelement T2. Die dritte und die vierte Elektrode E3, E4 sind miteinander direkt elektrisch verbunden. Über ein erstes Widerstandselement 25, dessen Widerstandswert beispielsweise zwischen 7 MOhm und 8 MOhm liegen kann, sowie über ein zweites Widerstandselement 26 sind die Elektroden E3, E4 mit einem negativen Pol des Kondensators C verbunden. Des Weiteren sind die Elektroden E3, E4 mit der Logik-Einheit 23 verbunden.

Die Funktionsweise der Vorrichtung 20 kann wie folgt beschrieben werden. Ist der Kondensator C vollständig entladen, so fließt zunächst im Wesentlichen der gesamte Kriechstrom Ik in den Sensorknoten 21 hinein und lädt den Kondensator C auf. Zeitkonstante der Aufladung ist durch die Parameter des Kondensators C beeinflusst. Mittels des Entladewiderstandes Re wird die Empfindlichkeit der Vorrichtung 20 in der Weise bestimmt, dass bei Kriechströmen, die unterhalb eines Stromschwellenwertes liegen, der Kondensator C nicht bis zu einer Energiespeicherspannung bzw. Kondensatorspannung Uc aufgeladen werden kann, die einem vorbestimmten Spannungsschwellenwert Us entspricht. Ist der Kriechstrom höher als der Stromschwellenwert, so wird der Kondensator C weiter aufgeladen, bis die am Kondensator C anstehende Kondensatorspannung Uc den Spannungsschwellenwert erreicht, Uc >= Us. Die Zeitspanne bis zu diesem Zeitpunkt ist desto kürzer, je höher der Kriechstrom ist. Das Erreichen oder Überschreiten des Spannungsschwellenwertes wird von der Logik-Einheit 23 detektiert. Diese weist wiederum den Radio-Transmitter 24 an, ein Funksignal auszusenden. Die zum Aussenden des Funksignals benötigte Energie wird dem Kondensator C entnommen. Durch passende Wahl der Kapazität des Energiespeichers oder durch Einstellung des Energieverbrauchs des Funkmoduls, ggf. mittels parallel geschaltetem Entladewiderstand, wird geeigneterweise sichergestellt, dass der Energiespeicher auf einen Pegel deutlich unterhalb des Schwellwerts entladen wird, zum Beispiel auf 60% des Auslöse-Schwellwerts. (Die Elektronik soll bis zum Abschluss des Funksendevorgangs funktionsfähig sein und kontrolliert arbeiten. Dies ist nicht möglich bei Entladung des Energiespeichers bis auf "null" Volt.) Fließt danach der Kriechstrom weiterhin, so wiederholt sich der beschriebene Auflade- und Sendevorgang erneut. Eine Empfangseinheit 25 kann das Funksignal derart verarbeiten und analysieren, dass die Häufigkeit der Funksignale als Maß für den mittleren Kriechstrom (Mittelwertbildung über die Pausenzeit durch integrierende Wirkung des Energiespeichers und des parallelen Entladewiderstands (Tuning-Widerstand) verwendet werden kann. Das Funksignal kann ferner als zusätzliche Information eine mittels der dritten Elektrode E3 gemessene Spannung enthalten. Sind die dritte und die vierte Elektrode E3, E4 von der ersten und der zweiten Elektrode E1, E2 in Längsrichtung eines Isolators entfernt angeordnet, so entspricht diese gemessene Spannung einer Isolatorabschnittsspannung. Es wird nur eine der beiden Elektroden E3 oder E4 benötigt (Standard Band), ggf. können die Elektroden elektrisch verbunden werden.

## Patentansprüche

1. Vorrichtung (20) zum Messen eines Leckstromes mit
- einer ersten und einer zweiten Elektrode (E1, E2) zum Anordnen in einem Leckstrompfad,
- einem Energiespeicher (C), der ein Kondensator ist, der derart mit den Elektroden (E1, E2) verschaltet ist, dass er mittels des Leckstromes aufladbar ist, sowie mit
- einem Funkmodul (22), das mit dem Energiespeicher (C) verbunden und dazu eingerichtet ist, ein Funksignal zu senden, wenn eine Energiespeicherspannung am Energiespeicher (C) einen vorbestimmten Spannungsschwellwert erreicht oder überschreitet, wobei die Vorrichtung (4) eine Antenne umfasst, mittels der das Funksignal gesendet wird, **dadurch gekennzeichnet, dass** eine der Elektroden (E2) wenigstens einen Teil der Antenne ausbildet.

2. Vorrichtung (20) nach Anspruch 1, wobei die erste Elektrode (E1) mit einem ersten Pol des Energiespeichers (C) und die zweite Elektrode (E2) mit einem zweiten Pol des Energiespeichers (C) verbunden sind, und das Funkmodul (22) elektrisch parallel zum Energiespeicher (C) angeordnet ist.

3. Vorrichtung (20) nach einem der Ansprüche 1 oder 2, wobei die Vorrichtung einen Entladewiderstand (Re) umfasst, der derart mit dem Energiespeicher (C) verbunden ist, dass die Energiespeicherspannung erst dann den Spannungsschwellwert erreichen kann, wenn der Leckstrom einen vorbestimmten Stromschwellwert erreicht oder überschreitet.

4. Vorrichtung (20) nach Anspruch 3, wobei der Entladewiderstand (Re) elektrisch parallel zum Energiespeicher (C) angeordnet ist.

5. Vorrichtung (20) nach einem der Ansprüche 3 oder 4, wobei der Widerstandswert des Entladewiderstandes (Re) gezielt veränderbar ist.

6. Vorrichtung (20) nach einem der vorangehenden Ansprüche, wobei ein Ableiter (F) in Parallelschaltung zum Energiespeicher (C) vorgesehen ist.

7. Vorrichtung (4) nach Anspruch 1, wobei Reflektordrosseln (D1, D2) vorgesehen sind, die in die eine der Elektroden (E2) zur Festlegung einer Trägerfrequenz des Funksignals eingefügt sind.

8. Vorrichtung (20) nach einem der vorangehenden Ansprüche, wobei die Vorrichtung (20) ferner eine dritte Elektrode (E3) umfasst, die mit dem Funkmodul (22) verbunden ist, so dass eine Spannung zwischen der dritten Elektrode (E3) und dem Funkmodul (22) messbar ist.

9. Vorrichtung (20) nach Anspruch 8, wobei die dritte Elektrode (E3) mittels eines äußerlich isolierten Widerstandsbandes mit dem Funkmodul (22) und/oder mit dem Energiespeicher (C) verbunden ist.

10. Vorrichtung (20) nach einem der vorangehenden Ansprüche, wobei die erste und die zweite Elektrode (E1, E2) über eine Gleichrichterbrücke (G) mit dem Energiespeicher (C) verbunden sind.

11. Vorrichtung (4) nach einem der vorangehenden Ansprüche, wobei die erste und die zweite Elektrode (E1, E2) jeweils ringförmig und konzentrisch zueinander angeordnet sind.

12. Vorrichtung (4) nach einem der vorangehenden Ansprüche, wobei die erste und die zweite Elektrode (E1, E2) auf einem gemeinsamen Trägerelement (T1) angeordnet und mit diesem verbunden sind.

13. Elektrischen Anlage (1), **gekennzeichnet durch** eine Vorrichtung (4, 20) zum Messen eines in der Anlage (1) fließenden Leckstromes (Ik) nach einem der Ansprüche 1 bis 12.

14. Elektrische Anlage (1) nach Anspruch 13, mit einem Leiter, der von einem Isolator (3) umgeben ist, wobei die Vorrichtung (4, 20) zum Messen eines über den Isolator fließenden Leckstromes (Ik) eingerichtet ist.

15. Elektrische Anlage (1) nach Anspruch 13, wobei die Anlage (1) einen Ableiter mit einem Aktivteil umfasst, wobei die Vorrichtung (4, 20) zum Messen eines durch das Aktivteil fließenden Leckstromes eingerichtet ist.

16. Verfahren zum Messen eines Leckstromes mit den Verfahrensschritten
- Aufladen eines Energiespeichers (C), der ein Kondensator ist, der mit einer ersten und einer zweiten Elektrode (E1, E2) verbunden ist, die in einem Leckstrompfad des zu messenden Leckstromes angeordnet sind,
- Aussenden eines Funksignals, wobei das Funksignal mittels eines mit dem Energiespeicher (C) verbundenen Funkmoduls (22) gesendet wird, sobald eine Energiespeicherspannung am Energiespeicher (C) einen vorbestimmten Spannungsschwellwert erreicht oder überschreitet, wobei das Funksignal mittels einer Antenne gesendet wird, **dadurch gekennzeichnet, dass** eine der Elektroden (E2) wenigstens einen Teil der Antenne ausbildet.

## Claims

1. Device (20) for measuring a leakage current, comprising
- a first and a second electrode (E1, E2) for arrangement in a leakage current path,
- an energy store (C) that is a capacitor that is connected up to the electrodes (E1, E2) in such a way that it is able to be charged by means of the leakage current, and comprising
- a radio module (22) that is connected to the energy store (C) and is designed to transmit a radio signal if an energy store voltage at the energy store (C) reaches or exceeds a predetermined voltage threshold value, wherein the device (4) comprises an antenna, by means of which the radio signal is transmitted, **characterized in that** one of the electrodes (E2) forms at least part of the antenna.

2. Device (20) according to Claim 1, wherein the first electrode (E1) is connected to a first pole of the energy store (C) and the second electrode (E2) is connected to a second pole of the energy store (C), and the radio module (22) is arranged electrically in parallel with the energy store (C).

3. Device (20) according to either of Claims 1 and 2, wherein the device comprises a discharge resistor (Re) that is connected to the energy store (C) in such a way that the energy store voltage can reach the voltage threshold value only when the leakage current reaches or exceeds a predetermined current threshold value.

4. Device (20) according to Claim 3, wherein the discharge resistor (Re) is arranged electrically in parallel with the energy store (C).

5. Device (20) according to either of Claims 3 and 4, wherein the resistance value of the discharge resistor (Re) is selectively variable.

6. Device (20) according to one of the preceding claims, wherein an arrester (F) is provided connected in parallel with the energy store (C).

7. Device (4) according to Claim 1, wherein reflector inductors (D1, D2) are provided, which are inserted into one of the electrodes (E2) in order to define a carrier frequency of the radio signal.

8. Device (20) according to one of the preceding claims, wherein the device (20) also comprises a third electrode (E3) that is connected to the radio module (22), with the result that a voltage between the third electrode (E3) and the radio module (22) is able to be measured.

9. Device (20) according to Claim 8, wherein the third electrode (E3) is connected to the radio module (22) and/or to the energy store (C) by means of an externally insulated resistance band.

10. Device (20) according to one of the preceding claims, wherein the first and the second electrode (E1, E2) are connected to the energy store (C) via a rectifier bridge (G).

11. Device (4) according to one of the preceding claims, wherein the first and the second electrode (E1, E2) are each arranged in annular form and concentrically in relation to one another.

12. Device (4) according to one of the preceding claims, wherein the first and the second electrode (E1, E2) are arranged on, and connected to, a common carrier element (T1).

13. Electrical installation (1), **characterized by** a device (4, 20) for measuring a leakage current (Ik) flowing in the installation (1) according to one of Claims 1 to 12.

14. Electrical installation (1) according to Claim 13, comprising a conductor that is surrounded by an insulator (3), wherein the device (4, 20) is designed to measure a leakage current (Ik) flowing via the insulator.

15. Electrical installation (1) according to Claim 13, wherein the installation (1) comprises an arrester with an active part, wherein the device (4, 20) is designed to measure a leakage current flowing through the active part.

16. Method for measuring a leakage current, comprising the method steps of
- charging an energy store (C) that is a capacitor that is connected to a first and a second electrode (E1, E2) that are arranged in a leakage current path of the leakage current to be measured,
- emitting a radio signal, wherein the radio signal is transmitted by means of a radio module (22) connected to the energy store (C) as soon as an energy store voltage at the energy store (C) reaches or exceeds a predetermined voltage threshold value, wherein the radio signal is transmitted by means of an antenna, **characterized in that** one of the electrodes (E2) forms at least part of the antenna.

## Revendications

1. Dispositif (20) de mesure d'un courant de fuite comprenant
- une première et une deuxième électrodes (E1, E2) à monter dans un chemin de courant de fuite,
- un accumulateur (C) d'énergie, qui est un condensateur, qui est connecté avec les électrodes (E1, E2) de manière à pouvoir être chargé au moyen du courant de fuite, ainsi que
- un module (22) radio, qui est relié à l'accumulateur (C) d'énergie et qui est agencé pour envoyer un signal radio, si une tension aux bornes de l'accumulateur (C) d'énergie atteint ou dépasse une valeur de seuil de tension déterminée à l'avance, dans lequel le dispositif (4) comprend une antenne, au moyen de laquelle le signal radio est envoyé, **caractérisé en ce que** l'une des électrodes (E2) constitue au moins une partie de l'antenne.

2. Dispositif (20) suivant la revendication 1, dans lequel la première électrode (E1) est connectée à un premier pôle de l'accumulateur (C) d'énergie et la deuxième électrode (E2) à un deuxième pôle de l'accumulateur (C) d'énergie, et le module (22) radio est monté en parallèle électriquement avec l'accumulateur (C) d'énergie.

3. Dispositif (20) suivant l'une des revendications 1 ou 2, dans lequel le dispositif comprend une résistance (Re) de décharge, qui est connectée à l'accumulateur (C) d'énergie, de manière à ce que la tension de l'accumulateur d'énergie ne puisse atteindre la valeur de seuil de tension que si le courant de charge atteint ou dépasse une valeur de seuil de courant déterminée à l'avance.

4. Dispositif (20) suivant la revendication 3, dans lequel la résistance (Re) de décharge est montée électriquement en parallèle avec l'accumulateur (C) d'énergie.

5. Dispositif (20) suivant l'une des revendications 3 ou 4, dans lequel la valeur de la résistance (Re) de décharge est variable de manière ciblée.

6. Dispositif (20) suivant l'une des revendications précédentes, dans lequel il est prévu un parafoudre (F) dans un montage en parallèle avec l'accumulateur (C) d'énergie.

7. Dispositif (4) suivant la revendication 1, dans lequel il est prévu des bobines (D1, D2) de réflecteur, qui sont insérées dans la une des électrodes (E2) pour la fixation d'une fréquence porteuse du signal radio.

8. Dispositif (20) suivant l'une des revendications précédentes, dans lequel le dispositif (20) comprend en outre une troisième électrode (E3), qui est connectée au module (22) radio, de manière à pouvoir mesurer une tension entre la troisième électrode (E3) et le module (22) radio.

9. Dispositif (20) suivant la revendication 8, dans lequel la troisième électrode (E3) est connectée au module (22) radio et/ou à l'accumulateur (C) d'énergie au moyen d'une bande de résistance isolée extérieurement.

10. Dispositif (20) suivant l'une des revendications précédentes, dans lequel la première et la deuxième électrode (E1, E2) sont connectées à l'accumulateur (C) d'énergie par un pont (G) redresseur.

11. Dispositif (4) suivant l'une des revendications précédentes, dans lequel la première et la deuxième électrode (E1, E2) sont montées respectivement annulairement et concentriquement l'une à l'autre.

12. Dispositif (4) suivant l'une des revendications précédentes, dans lequel la première et la deuxième électrodes (E1, E2) sont montées sur un élément (T1) support commun et sont reliées à celui-ci.

13. Installation (1) électrique **caractérisée par** un dispositif (4, 20) de mesure d'un courant (Ik) de fuite passant dans l'installation (1) suivant l'une des revendications 1 à 12.

14. Installation (1) électrique suivant la revendication 13, comprenant un conducteur, qui est entouré d'un isolateur (3), dans lequel le dispositif (4, 20) est agencé pour la mesure d'un courant (Ik) de fuite passant dans l'isolateur.

15. Installation (1) électrique suivant la revendication 13, dans laquelle l'installation (1) comprend un parafoudre ayant une partie active, dans laquelle le dispositif (4, 20) est agencé pour la mesure d'un courant de fuite passant dans la partie active.

16. Procédé de mesure d'un courant de fuite ayant les stades de procédé
- charge d'un accumulateur (C) d'énergie, qui est un condensateur, qui est connecté à une première et une deuxième électrodes (E1, E2), qui sont montées dans un chemin du courant de fuite à mesurer,
- envoi d'un signal radio, dans lequel on envoie le signal radio au moyen d'un module (22) radio connecté à l'accumulateur (C) d'énergie, dès qu'une tension aux bornes de l'accumulateur (C) d'énergie atteint ou dépasse une valeur de seuil de tension déterminée à l'avance, dans lequel on envoie le signal radio au moyen d'une antenne, **caractérisé en ce que** l'une des électrodes (E2) constitue au moins une partie de l'antenne.
